# EUROPEAN PATENT APPLICATION

(11) **EP 4 412 434 A1**
(43) Date of publication of application: **07.08.2024**
(21) Application number: 24154524.3
(22) Date of filing: 29.01.2024
(51) Int. Cl.: H10K 59/80, H10K 50/844

(54) **DISPLAY PANEL AND MANUFACTURING METHOD OF THE SAME**

(30) Priority: 31.01.2023 KR 20230012610
(71) Applicant: Samsung Display Co., Ltd., Yongin-si, Gyeonggi-do 17113 (KR)
(72) Inventor: HAN, Jae-Bum, 17113 Yongin-si (KR); GONG, Dong-Hyun, 17113 Yongin-si (KR); KIM, Moonsung, 17113 Yongin-si (KR); KIM, Hyosung, 17113 Yongin-si (KR); YEON, Ki Young, 17113 Yongin-si (KR); WOO, Sung-Wook, 17113 Yongin-si (KR); LEE, Hyun-Ju, 17113 Yongin-si (KR); HAN, Seokkyu, 17113 Yongin-si (KR)
(74) Representative: Taor, Simon Edward William

(57) **Abstract**

Provided is a display panel including a base layer including an active region, and a peripheral region adjacent to the active region, a light-emitting element layer above the base layer, and an encapsulation layer above the light-emitting element layer, and including a first inorganic layer, a second inorganic layer above the first inorganic layer, an organic layer above the second inorganic layer, and a third inorganic layer above the organic layer, wherein the second inorganic layer includes a non-metal oxide and wherein the second inorganic layer and the organic layer overlap the active region.

## Description

### CROSS-REFERENCE TO RELATED APPLICATION

This application claims priority to, and the benefit of, Korean Patent Application No. 10-2023-0012610, filed on January 31, 2023, in the Korean Intellectual Property Office.

### BACKGROUND

### 1. Field

The present disclosure herein relates to a display panel including an encapsulation layer for covering a light-emitting element, and to a method for manufacturing the display panel.

### 2. Description of the Related Art

An electronic device includes an active region activated in response to an electrical signal. The electronic device senses pressure applied from the outside through the active region, and at the same time, displays various images to provide information to a user.

Meanwhile, the electronic device may include a light-emitting element using an organic light-emitting material, a quantum dot light-emitting material, or the like. Such a light-emitting element is very vulnerable to oxygen and moisture, and when oxygen and moisture penetrate from the outside, a variety of defects may be generated. Therefore, the development of an encapsulation layer for protecting the light-emitting element is underway.

### SUMMARY

The present disclosure provides a display panel having improved reliability by including an encapsulation layer with improved coating quality.

The present disclosure also provides a method for manufacturing a display panel with improved reliability by applying a process for forming an encapsulation layer with improved coating quality.

One or more embodiments of the present disclosure provides a display panel including a base layer including an active region, and a peripheral region adjacent to the active region, a light-emitting element layer above the base layer, and an encapsulation layer above the light-emitting element layer, and including a first inorganic layer, a second inorganic layer above the first inorganic layer, an organic layer above the second inorganic layer, and a third inorganic layer above the organic layer, wherein the second inorganic layer includes a non-metal oxide and wherein the second inorganic layer and the organic layer overlap the active region.

A portion of the first inorganic layer overlapping the peripheral region may contact the third inorganic layer.

An area of the second inorganic layer and an area of the organic layer may be smaller than an area of the first inorganic layer in plan view.

The first inorganic layer may include silicon oxynitride, wherein the second inorganic layer includes silicon oxide or silicon oxynitride, and wherein a content of oxygen atoms in the second inorganic layer is greater than a content of oxygen atoms in the first inorganic layer.

A composition ratio of the oxygen atoms in the second inorganic layer may be about 0.15 to about 1.0 based on silicon atoms.

The second inorganic layer may be hydrophilic.

At least a portion of a surface of the first inorganic layer adjacent to the third inorganic layer may be hydrophobic, wherein the at least a portion of the first inorganic layer includes a region overlapping the peripheral region in plan view.

A roughness of a surface of the organic layer adjacent to the third inorganic layer may be about 10 nm or less.

The base layer may include a glass substrate.

The peripheral region may surround the active region in plan view.

In one or more embodiments of the present disclosure, a display panel includes a base layer including an active region, and a peripheral region adjacent to the active region, a light-emitting element in the active region, a dam pattern in the peripheral region, a first inorganic layer covering the light-emitting element, a second inorganic layer above the first inorganic layer and including a non-metal oxide, an organic layer above the second inorganic layer, and a third inorganic layer above the organic layer, wherein the second inorganic layer and the organic layer are inside of the dam pattern in plan view, and wherein an edge of the first inorganic layer and an edge of the third inorganic layer are outside of the dam pattern in plan view.

The peripheral region may surround the active region in plan view, wherein the dam pattern surrounds the active region in plan view.

An edge of the second inorganic layer and an edge of the organic layer may be substantially aligned, wherein the edge of the first inorganic layer and the edge of the third inorganic layer are substantially aligned.

The first inorganic layer may include silicon oxynitride, wherein the second inorganic layer includes silicon oxide or silicon oxynitride, and wherein a content of oxygen atoms in the second inorganic layer is greater than a content of oxygen atoms in the first inorganic layer.

The second inorganic layer may be hydrophilic.

At least a portion of a surface of the first inorganic layer adjacent to the third inorganic layer may be hydrophobic, wherein the at least a portion of the first inorganic layer includes a region overlapping the peripheral region in plan view.

A roughness of a surface of the organic layer adjacent to the third inorganic layer may be about 10 nm or less.

The base layer may include a glass substrate.

In one or more embodiments of the present disclosure, a method for manufacturing a display panel includes preparing a preliminary display panel including a base layer having an active region, and a peripheral region adjacent to the active region, and a light-emitting element layer above the base layer, forming a first inorganic layer on the preliminary display panel using a first mask, forming a second inorganic layer including a non-metal oxide on the first inorganic layer using a second mask, forming an organic layer on the second inorganic layer, and forming a third inorganic layer on the organic layer using the first mask, wherein an area of an opening of the first mask is larger than an area of an opening of the second mask, wherein the opening of the first mask overlaps the active region and the peripheral region, and wherein the opening of the second mask overlaps the active region, and does not overlap the peripheral region.

The first inorganic layer may include silicon oxynitride, wherein the second inorganic layer includes silicon oxide or silicon oxynitride, and wherein a content of oxygen atoms in the second inorganic layer is greater than a content of oxygen atoms in the first inorganic layer.

The second inorganic layer may be hydrophilic.

The method may further include subjecting at least a portion of a surface of the first inorganic layer, which includes a region overlapping the peripheral region, to hydrophobization treatment.

The hydrophobization treatment may include plasma treatment using NF₃, SF₆, CF₄, or HF gas.

According to an aspect, there is provided a display panel as set out in claim 1. Additional features are set out in claims 2 to 6 and 11 and 12. According to an aspect, there is provided a display panel as set out in claim 7. Additional features are set out in claims 8 to 12. According to an aspect, there is provided a method as set out in claim 13. Additional features are set out in claims 14 and 15.

### BRIEF DESCRIPTION OF THE DRAWINGS

The accompanying drawings are included to provide a further understanding of the present disclosure, and are incorporated in, and constitute a part of, this specification. The drawings illustrate embodiments of the present disclosure and, together with the description, serve to explain aspects of the present disclosure. In the drawings:
FIG. 1 is a perspective view of a display device according to one or more embodiments of the present disclosure;
FIG. 2 is a perspective view of a display panel according to one or more embodiments of the present disclosure;
FIG. 3 is a cross-sectional view of a display panel according to one or more embodiments of the present disclosure;
FIG. 4 is a cross-sectional view of a display panel according to one or more embodiments of the present disclosure;
FIG. 5 is a plan view of an encapsulation layer according to one or more embodiments of the present disclosure;
FIG. 6A and FIG. 6B are plan views of an inorganic layer according to one or more embodiments of the present disclosure;
FIG. 7 is a flowchart of a method for manufacturing a display panel according to one or more embodiments of the present disclosure; and
FIG. 8A to FIG. 8E are each a plan view showing one operation of a method for manufacturing a display panel according to one or more embodiments of the present disclosure.
FIG. 9 is a cross-sectional photograph of an encapsulation layer according to one or more embodiments of the present disclosure;

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The present disclosure covers all modifications, equivalents, and replacements within the idea and technical scope of the present disclosure. Further, each of the features of the various embodiments of the present disclosure may be combined or combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. In other instances, well-known structures and devices are shown in block diagram form to avoid unnecessarily obscuring various embodiments.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions, such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression, such as "at least one of A and B" and "at least one of A or B" may include A, B, or A and B. As used herein, "or" generally means "and/or," and the term "and/or" includes any and all combinations of one or more of the associated listed items. For example, the expression, such as "A and/or B" may include A, B, or A and B. Similarly, expressions, such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

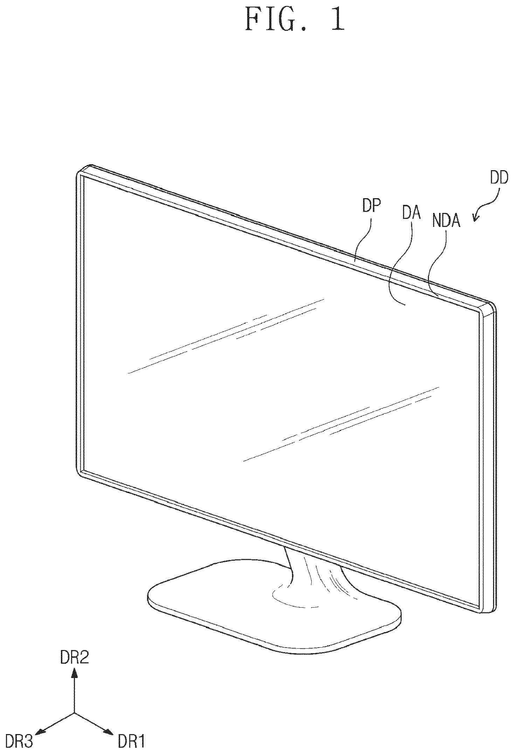

FIG. 1 is a perspective view of a display device DD according to one or more embodiments of the present disclosure.

The display device DD according to one or more embodiments of the present disclosure illustrated in FIG. 1 may be a device activated in response to an electrical signal. For example, the display device DD may be a mobile phone, a tablet computer, a monitor, a laptop, a television, an external billboard, a car navigation system, a game console, a camera or a wearable device, but embodiments of the present disclosure are not limited thereto. In FIG. 1, the display device DD is illustrated as a monitor.

Meanwhile, in FIG. 1 and the following drawings, a first direction DR1, a second direction DR2, and a third direction DR3 are illustrated, and directions indicated by the first direction DR1, the second direction DR2, and the third direction DR3 described in the present disclosure are a relative concept, and may be converted to different directions. In the present disclosure, the first direction DR1 and the second direction DR2 are perpendicular to each other, and the third direction DR3 may be a normal direction with respect to a plane defined by the first direction DR1 and the second direction DR2.

In the present disclosure, a thickness direction of the display device DD may be a direction parallel to the third direction DR3, which is the normal direction with respect to the plane defined by the first direction DR1 and the second direction DR2. Therefore, a front surface (or an upper surface) and a rear surface (or a lower surface) of members constituting the display device DD may be defined based on the third direction DR3.

In the present disclosure, "on a plane" may mean being viewed on a plane parallel to the plane defined by the first direction DR1 and the second direction DR2. In the present disclosure, unless otherwise defined, "overlapping" may mean overlapping on a plane (e.g., in plan view).

Referring to FIG. 1, the display device DD according to one or more embodiments may display an image IM through a display region DA. The display region DA may include the plane defined by the first direction DR1 and the second direction DR2.

The display region DA of the display device DD of one or more embodiments illustrated in FIG. 1 is illustrated as including only the plane defined by the first direction DR1 and the second direction DR2. However, unlike what is illustrated, the display region DA may further include a curved surface bent from at least one side of the plane defined by the first direction DR1 and the second direction DR2. For example, the display region DA may include two curved surfaces respectively bent from both side of the plane defined by the first direction DR1 and the second direction DR2, and the display region DA may include four curved surfaces respectively bent from four sides of the plane.

A non-display region NDA may be located adjacent to the display region DA. The non-display region NDA may surround the display region DA (e.g., in plan view). Accordingly, the shape of the display region DA may be substantially defined by the non-display region NDA. However, this is only illustrated as an example, and the non-display region NDA may be located adjacent to only one side of the display region DA, or may be omitted. The display device DD according to one or more embodiments of the present disclosure may include the display region ED of various shapes, and is not limited to any one embodiment.

The display device DD according to one or more embodiments may sense an external input applied from the outside. The external input may include various forms of inputs provided from the outside of the display device DD. For example, the external input may include not only a contact by a part of a user's body, such as a hand, but also an external input applied in close proximity, or adjacent to the display device DD at a distance (e.g., a predetermined distance, which may be referred to as hovering). Also, the external input may have various forms, such as force, pressure, temperature, light, and the like.

The display device DD of one or more embodiments may be a display module. The display module may be a component configured to generate images and sense pressure applied from the outside. The display module according to one or more embodiments may include a display panel DP. The display module of one or more embodiments may further include a sensor layer and an optical layer located on the display panel DP. However, embodiments of the present disclosure are not limited thereto, and the sensor layer or the optical layer may be omitted in one or more embodiments.

The display device DD of one or more embodiments may further include various electronic modules. For example, an electronic module may include at least one of a camera, a speaker, a light sensing sensor, or a heat sensing sensor. The electronic module may sense an external object received from the outside, or provide a sound signal, such as voice to the outside. The electronic module may include a plurality of components, and is not limited to any one embodiment.

Meanwhile, the display device DD of one or more embodiments may be a flexible display device capable of folding, bending, sliding, rolling, or the like.

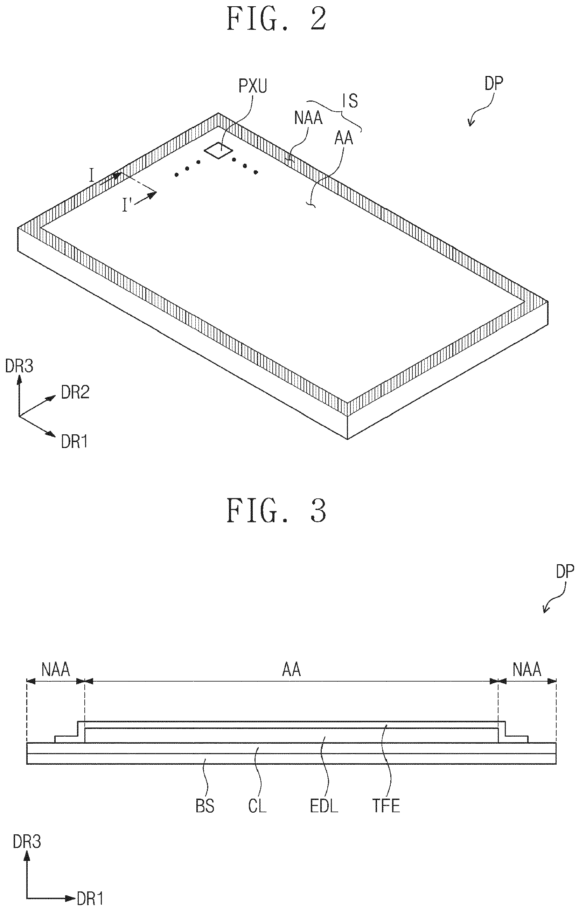

FIG. 2 is a perspective view of the display panel DP according to one or more embodiments of the present disclosure.

Referring to FIG. 2, the display panel DP may display an image through a display surface IS. The display surface IS may be parallel to the plane defined by the first direction DR1 and the second direction DR2. An upper surface of a member located on the uppermost side of the display panel DP in the third direction DR3 may be defined as the display surface IS.

A normal direction of the display surface IS, that is, a thickness direction of the display panel DP, may be indicated by the third direction DR3. A front surface (or an upper surface) and a rear surface (or a lower surface) of each layers or units described hereinafter may be distinguished by the third direction DR3.

The display panel DP may include an active region AA and a peripheral region NAA. Unit pixels PXU are located in the active region AA, and the unit pixels PXU are not located in the peripheral region NAA. The peripheral region NAA may be defined along the edge of the display surface IS. The peripheral region NAA may surround the active region AA. In one or more embodiments of the present disclosure, the peripheral region NAA may be omitted, or may be located on only one side of the active region AA.

In one or more embodiments, the active region AA of the display panel DP may correspond to the display region DA (see FIG. 1) of the display device DD (see FIG. 1), and the peripheral region NAA of the display panel DP may correspond to the non-display region NDA (see FIG. 1) of the display device DD (see FIG. 1).

FIG. 2 illustrates a planar display panel DP, but the display panel DP may have a curved shape, be capable of folding, be capable of rolling, or be capable of sliding from a housing.

The unit pixels PXU illustrated in FIG. 2 may define a pixel row or a pixel column. A unit pixel PXU may be a minimum repeating unit, and the unit pixel PXU may include at least one pixel. The unit pixel PXU may include a plurality of pixels that provide light of different colors.

FIG. 3 is a cross-sectional view of the display panel DP according to one or more embodiments of the present disclosure. FIG. 3 schematically shows a cross-section of the display panel DP of one or more embodiments.

Referring to FIG. 3, the display panel DP of one or more embodiments may include a base layer BS, a circuit layer CL, a light-emitting element layer EDL, and an encapsulation layer TFE.

The base layer BS may be a member that provides a base surface on which the circuit layer CL is located. The base layer BS may be a rigid substrate, or a flexible substrate capable of bending, folding, rolling, or the like.

The circuit layer CL may be located on/above the base layer BS. The circuit layer CL may include an insulation layer, a semiconductor pattern, a conductive pattern, a signal line, and the like. An insulation layer, a semiconductor layer, and a conductive layer are formed above the base layer BS by coating, deposition, or the like, and thereafter, the insulation layer, the semiconductor layer, and the conductive layer may be selectively patterned through a photolithography process and an etching process performed a plurality of times. Thereafter, the semiconductor pattern, the conductive pattern, and the signal line included in the circuit layer CL may be formed.

The light-emitting element layer EDL may be located on/above the circuit layer CL. The light-emitting element layer EDL may include a light-emitting element. For example, the light-emitting element may be an organic light-emitting element, an inorganic light-emitting element, an organic-inorganic light-emitting element, a micro LED, a nano LED, a quantum dot light-emitting element, an electrophoretic element, an electro wetting element, or the like.

The encapsulation layer TFE may be located on/above the light-emitting element layer EDL. The encapsulation layer TFE may cover the light-emitting element layer EDL. The encapsulation layer TFE may be located in the active region AA in which the light-emitting element layer EDL is located, and may be arranged to extend in the peripheral region NAA in which the light-emitting element layer EDL is not located. The encapsulation layer TFE may be located to cover at least a portion of the peripheral region NAA. For example, as illustrated in FIG. 3, the encapsulation layer TFE may be located to cover a portion of the peripheral region NAA. On the other hand, the encapsulation layer TFE may be located to cover all of the peripheral region NAA. The encapsulation layer TFE may protect the light-emitting element EDL from foreign substances, such as moisture, oxygen, and dust particles. The encapsulation layer TFE according to one or more embodiments of the present disclosure will be described in more detail later.

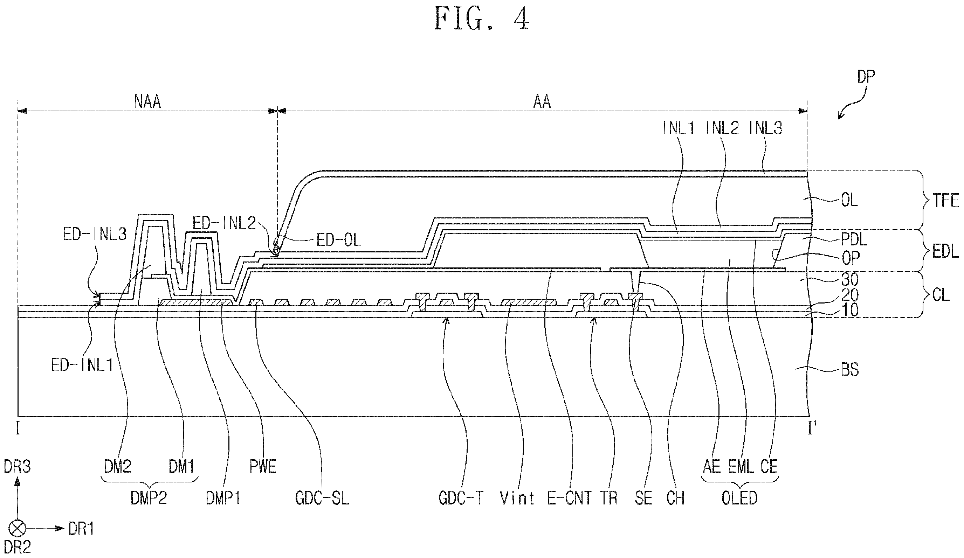

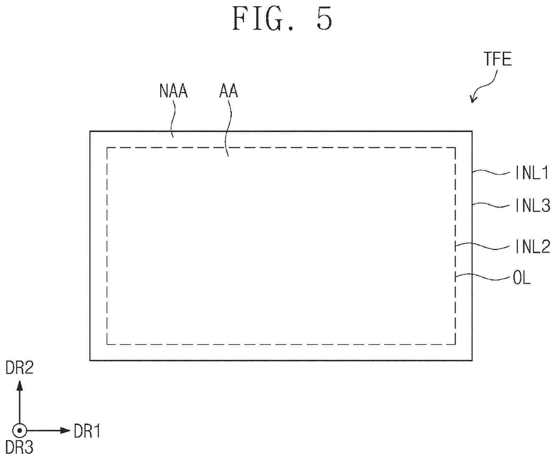

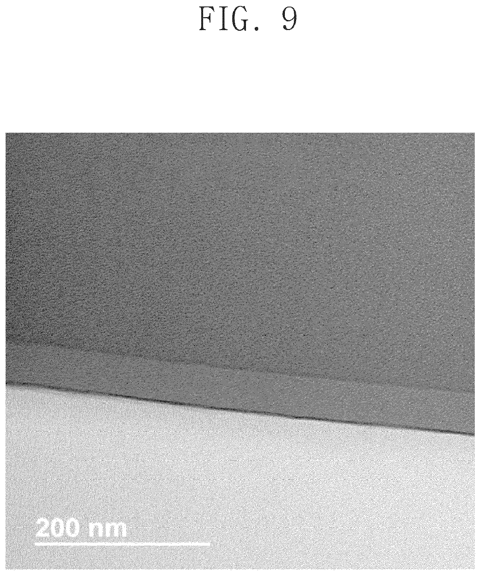

FIG. 4 is a cross-sectional view of the display panel DP according to one or more embodiments of the present disclosure. FIG. 4 shows a cross-section taken along the line I-I' of FIG. 2. FIG. 5 is a plan view of the encapsulation layer TFE according to one or more embodiments of the present disclosure. FIG. 5 may be a plan view of each layer included in the encapsulation layer TFE viewed in the third direction DR3. FIG. 9 is a cross-sectional photograph of the encapsulation layer TFE (see FIG. 4) according to one or more embodiments of the present disclosure.

The base layer BS may be a member that provides a base surface on which the circuit layer CL is located. The base layer BS includes the active region AA and the peripheral region NAA located adjacent to the active region AA. A light-emitting element OLED is located in the active region AA, and dam patterns DMP1 and DMP2 are located in the peripheral region NAA.

In one or more embodiments of the present disclosure, the base layer BS may include a glass substrate. In this case, the base layer BS may receive a large amount of stress during an ashing process to be described later. Therefore, if a typical encapsulation layer is applied, defects, such as the generation of fine cracks or the like, may be caused in the encapsulation layer during the ashing process. Because the encapsulation layer TFE according to the present disclosure has a structure with improved coating quality, the ashing process may be omitted, reduced, or minimized, so that defects, such as fine cracks, may not be generated even if the base layer BS includes a glass substrate.

In one or more embodiments of the present disclosure, the base layer BS may include a synthetic resin film. The synthetic resin film may include a thermosetting resin. For example, the synthetic resin film may be a polyimide-based resin layer, and the material thereof is not particularly limited. The synthetic resin film may include at least one among an acrylic resin, methacrylic resin, polyisoprene, a vinyl-based resin, an epoxy-based resin, a urethane-based resin, a cellulose-based resin, a siloxane-based resin, a polyamide-based resin, and a perylene-based resin. In addition, the base layer BS may include a metal substrate, an organic/inorganic composite material substrate, or the like.

The circuit layer CL may include a first insulation layer 10, a second insulation layer 20, and a third insulation layer 30. The first insulation layer 10 and the second insulation layer 20 may include an inorganic film. The third insulation layer 30 may include an organic film. The circuit layer CL may further include a buffer layer located between the base layer BS and the first insulation layer 10. The buffer layer may include an inorganic film. The buffer layer may include a plurality of inorganic films.

The circuit layer CL may include a power electrode PWE, signal lines GDC-SL, a transistor GDC-T, a signal line Vint for providing an initialization voltage, a connection electrode E-CNT, and a pixel transistor TR. The pixel transistor TR may include an oxide semiconductor. The oxide semiconductor may include a plurality of regions distinguished according to whether a metal oxide has been reduced or not. A region in which the metal oxide has been reduced (hereinafter, a reduction region) has greater conductivity than a region in which the metal oxide has not been reduced (hereinafter, a non-reduction region). The reduction region substantially serves as a source/drain or signal line of a transistor. The non-reduction region substantially corresponds to an active region (or a semiconductor region, or a channel region) of a transistor. In other words, a portion of the pixel transistor TR may be an active region of a transistor, another portion(s) thereof may be a source/drain region of the transistor, and the other portion thereof may be a signal transmissive region.

When the pixel transistor TR includes an oxide semiconductor, the pixel transistor TR may be more vulnerable to moisture and oxygen. Therefore, if a typical encapsulation layer is applied, fine cracks are generated in the encapsulation layer during an ashing process, so that moisture and oxygen may penetrate through the fine cracks, causing stains on the display panel DP. Because the encapsulation layer TFE according to the present disclosure has a structure with improved coating quality, the ashing process may be omitted, reduced, or minimized, so that defects, such as stains, may not be generated even if an oxide semiconductor is included.

The pixel transistor TR and the transistor GDC-T may be provided through the same process. The power electrode PWE may receive a voltage from the outside. The connection electrode E-CNT may be located on/above the third insulation layer 30. The connection electrode E-CNT may connect the power electrode PWE and a second electrode CE. The connection electrode E-CNT and a first electrode AE are provided through the same process, and thus may be located in the same layer, may include the same material, and may have the same thickness.

The light-emitting element layer EDL may include the light-emitting element OLED, and a pixel definition film PDL.

The light-emitting element OLED may include the first electrode AE, a light-emitting layer EML, and the second electrode CE. The first electrode AE may be located on/above the third insulation layer 30. The first electrode AE may be connected to an output electrode SE through a through-hole CH passing through the third insulation layer 30. In one or more embodiments, the light-emitting element OLED may further include a hole injection layer, a hole transport layer, an electron injection layer, or an electron transport layer.

The pixel definition film PDL may be an organic film. The pixel definition film PDL may define an opening OP. The opening OP of the pixel definition film PDL exposes at least a portion of the first electrode AE. The opening OP of the pixel definition film PDL may be named as a light-emitting opening to be distinguished from other openings.

In one or more embodiments, on an upper surface of the pixel definition film PDL, a spacer overlapping a portion of the pixel definition film PDL may be located. The spacer may have a single body shape with the pixel definition film PDL, or may be an insulation structure formed by an additional process.

Meanwhile, in one or more embodiments, the light-emitting element layer EDL may further include a capping layer located on the second electrode CE. The capping layer may protect the light-emitting element OLED located therebelow, and may improve light extraction efficiency. The capping layer may be an inorganic layer or an organic layer.

The encapsulation layer TFE may be located on/above the second electrode CE. The encapsulation layer TFE may include a plurality of thin films. The encapsulation layer TFE may include a first inorganic layer INL1, a second inorganic layer INL2, an organic layer OL, and a third inorganic layer INL3.

The encapsulation layer TFE may cover a step or a curve due to the light-emitting element layer EDL. For example, the organic layer OL may cover the step due to the light-emitting element layer EDL, and may provide a flat surface to the third inorganic layer INL3.

The thickness of the first inorganic layer INL1 may be about 7000 Å to about 1.2 µm. For example, the thickness of the first inorganic layer INL1 may be about 9000 Å to about 1 µm. The thickness of the second inorganic layer INL2 may be about 4000 Å to about 1.1 µm. For example, the thickness of the second inorganic layer INL2 may be about 6000 Å to about 7000 Å. The thickness of the organic layer OL may be about 6 µm to about 12 µm. For example, the thickness of the organic layer OL may be about 8.5 µm to about 11 µm.

Referring to FIG. 4 and FIG. 5 together, the second inorganic layer INL2 and the organic layer OL are located overlapping the active region AA on a plane. That is, the second inorganic layer INL2 and the organic layer OL may be located as to not overlap the peripheral region NAA.

Referring to FIG. 4, a portion of the first inorganic layer INL1 overlapping the peripheral region NAA on a plane may contact the third inorganic layer INL3. That is, between the first inorganic layer INL1 and the third inorganic layer INL3 located in the peripheral region NAA, the second inorganic layer INL2 and the organic layer OL may be omitted. Referring to FIG. 5, the area of the second inorganic layer INL2 and the area of the organic layer OL may be smaller than the area of the first inorganic layer INL1 on a plane.

The dam patterns DMP1 and DMP2 are located in the peripheral region NAA. FIG. 4 illustrates two dam patterns DMP1 and DMP2. The dam patterns DMP1 and DMP2 may be insulation dam patterns.

The dam patterns DMP1 and DMP2 may include a first dam pattern DMP1 and a second dam pattern DMP2. The first dam pattern DMP1 and the second dam pattern DMP2 may overlap the power electrode PWE. The first dam pattern DMP1 may have a single-layered structure, and the second dam pattern DMP2 may have a multi-layered structure. The first dam pattern DMP1 may be formed concurrently or substantially simultaneously with the pixel definition layer PDL. The thickness of the first dam pattern DMP1 may be greater than the thickness of the pixel definition layer PDL. A lower portion DM1 of the second dam pattern DMP2 may be formed concurrently or substantially simultaneously with the third insulation layer 30, and an upper portion DM2 of the second dam pattern DMP2 may be formed concurrently or substantially simultaneously with the pixel definition layer PDL.

The peripheral region NAA may surround the active region AA on a plane, and the dam patterns DMP1 and DMP2 may be located surrounding the active region AA. The dam patterns DMP1 and DMP2 may include a first dam pattern DMP1 and a second dam pattern DMP2. The first dam pattern DMP1 may be located on the inside of, or inwardly from, the second dam pattern DMP2. That is, the first dam pattern DMP1 may be located between the second dam pattern DMP2 and the active region AA on a plane.

On a plane, the second inorganic layer INL2 and the organic layer OL are located on the inside of, or inwardly from, the dam patterns DMP1 and DMP2, that is, inwardly from the first dam pattern DMP1. In addition, on a plane, an edge ED-INL1 of the first inorganic layer INL1 and an edge ED-INL3 of the third inorganic layer INL3 are located on the outside of the dam patterns DMP1 and DMP2, that is, outwardly from the second dam pattern DMP2.

On a plane, an edge ED-INL2 of the second inorganic layer INL2 and an edge ED-OL of the organic layer OL may be substantially aligned. In addition, on a plane, the edge ED-INL1 of the first inorganic layer INL1, and the edge ED-INL3 of the third inorganic layer INL3, may be substantially aligned.

On a plane, the distance between the edge ED-INL2 of the second inorganic layer INL2 and the edge ED-OL of the organic layer OL, and the edge ED-INL1 of the first inorganic layer INL1 and the edge ED-INL3 of the third inorganic layer INL3, may be, for example, about 300 µm or greater.

The first inorganic layer INL1 may serve to protect the light-emitting element OLED from oxygen and moisture. The first inorganic layer INL1 may include silicon nitride or silicon oxynitride. The second inorganic layer INL2 may include a non-metal oxide. The second inorganic layer INL2 may include silicon oxynitride or silicon oxide. The content of oxygen atoms in the second inorganic layer INL2 may be greater than the content of oxygen atoms in the first inorganic layer INL1. The composition ratio of the oxygen atoms in the second inorganic layer INL2 may be about 0.15 to about 1.0 based on silicon atoms. The composition ratio of nitrogen atoms in the second inorganic layer INL2 may be about 0.15 or less. The second inorganic layer INL2 may be hydrophilic. Therefore, if the organic layer OL is provided by coating a monomer on the second inorganic layer INL2, spreadability may be improved. The spreadability of the monomer may be improved. Meanwhile, the roughness of a surface adjacent to the organic layer OL of the second inorganic layer INL2 may be about 2 nm or greater. As the roughness is imparted to the second inorganic layer INL2, the spreadability of the monomer may be improved.

In addition, because the second inorganic layer INL2 is located only in the active region AA, the monomer coated if the organic layer OL is provided may not overflow into the peripheral region NAA. Therefore, an ashing process for removing the monomer overflown into the peripheral region NAA may be omitted, reduced, or minimized. FIG. 9 is a cross-sectional photograph of the encapsulation layer TFE of the structure according to the present disclosure, and it can be observed that the surface of the organic layer OL is not damaged by reducing or minimizing the ashing process. When the ashing process is omitted, reduced, or minimized, the roughness of a surface adjacent to the third inorganic layer INL3 of the organic layer OL may be about 10 nm or less.

The organic layer OL may serve as a buffer between the third inorganic layer INL3 and the first and second inorganic layers INL1 and INL2. That is, interlayer stress may be relaxed. The organic layer OL may include a monomer or a polymer.

The third inorganic layer INL3 may serve to reduce or prevent moisture and oxygen from penetrating. The third inorganic layer INL3 may have a two-layered structure having different compositions. For example, the third inorganic layer INL3 may include a lower layer having a relatively large content of oxygen atoms, and an upper layer having a relatively small content of oxygen atoms. The lower layer may be located on/above the organic layer OL, and the upper layer may be located on/above the lower layer. The third inorganic layer INL3 may include silicon nitride, or silicon oxynitride.

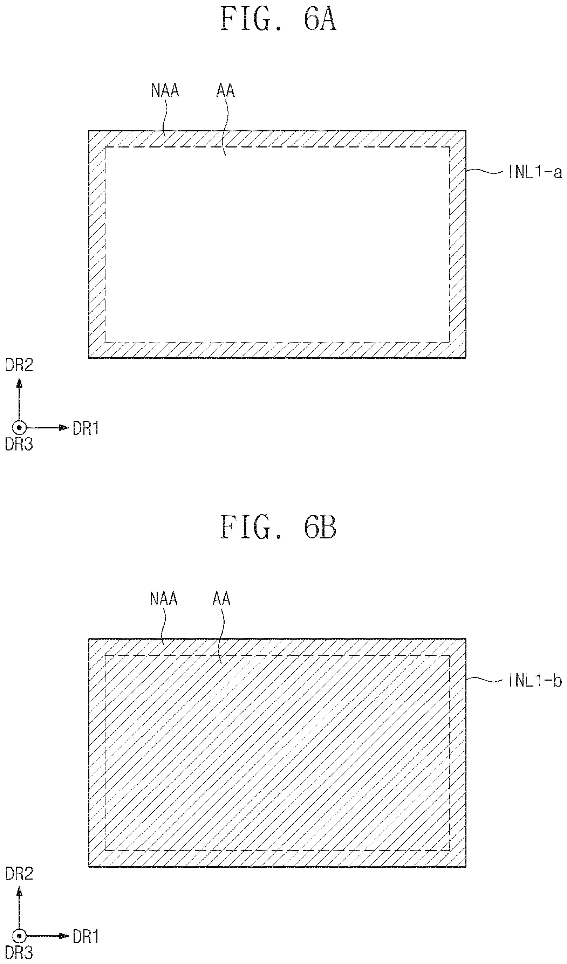

FIG. 6A and FIG. 6B are respectively plan views of inorganic layers INL1-a and INL1 -b according to one or more embodiments of the present disclosure. FIG. 6A and FIG. 6B may be respectively plan views schematically showing first inorganic layers INL1-a and INL1-b of one or more embodiments.

At least a portion of a surface adjacent to the third inorganic layer INL3 (see FIG. 4) of the first inorganic layer INL1 (see FIG. 4) may be hydrophobized, and therefor, hydrophobic. That is, a front surface of the first inorganic layer INL1 (see FIG. 4) may be hydrophobic, and a partial surface of the first inorganic layer INL1 (see FIG. 4) may be hydrophobic.

As illustrated in FIG. 6A, a hatched region overlapping the peripheral region NAA of the first inorganic layer INL1-a may be hydrophobized, thereby being hydrophobic. Therefore, if a monomer is coated on the second inorganic layer INL2 to provide the organic layer OL (see FIG. 4) in the active region AA, the monomer may be coated only in the active region AA without overflowing into the peripheral region NAA. Because the monomer is coated only in the active region AA, an ashing process for removing the monomer overflown into the peripheral region NAA may be omitted, or may be minimally performed. Because the ashing process is omitted or minimized, defects due to the generation of fine cracks in the encapsulation layer TFE (see FIG. 4) may be reduced or prevented.

In addition, as illustrated in FIG. 6B, the front surface of the first inorganic layer INL1, that is, a hatched region overlapping the active region AA and the peripheral region NAA may be subjected to hydrophobic conversion processing, thereby being hydrophobic. Even in this case, if a monomer is coated on the second inorganic layer INL2 to provide the organic layer OL (see FIG. 4) in the active region AA, the monomer may be coated only in the active region AA without overflowing into the peripheral region NAA. Accordingly, fine cracks may be reduced or prevented in the same manner as described with reference to FIG. 6A.

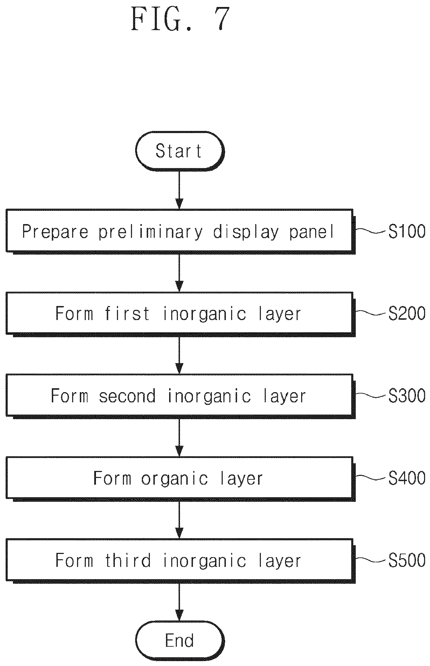

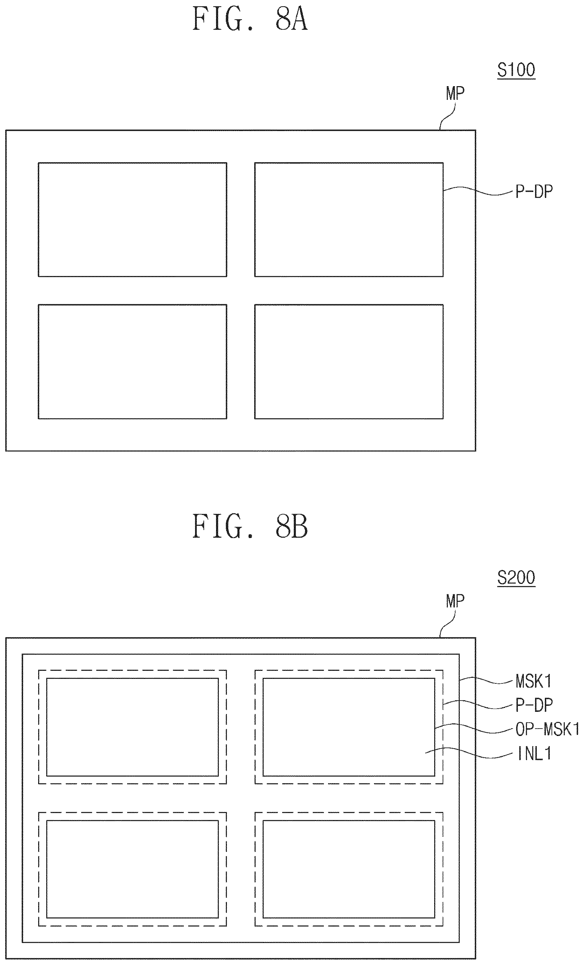

FIG. 7 is a flowchart of a method for manufacturing the display panel DP (see FIG. 3) according to one or more embodiments of the present disclosure. FIG. 8A to FIG. 8E are each a cross-sectional view showing one operation of the method for manufacturing the display panel DP (see FIG. 3) according to one or more embodiments of the present disclosure.

Referring to FIG. 7 and FIG. 8A to FIG. 8E together, the method for manufacturing the display panel DP (see FIG. 3) includes preparing a preliminary display panel P-DP S100, forming a first inorganic layer INL1 S200, forming a second inorganic layer INL2 S300, forming an organic layer OL S400, and forming a third inorganic layer INL3 S500.

In FIG. 7 and the following drawings, because the descriptions of the elements described above with reference to FIG. 1 to FIG. 6 may be equally applied, and thus, descriptions of the same elements will be omitted.

FIG. 8A schematically shows the operation S100 (see FIG. 7) of preparing the preliminary display panel P-DP. FIG. 8A to FIG. 8E illustrates that four preliminary display panels P-DP are prepared on a mother substrate MP, but the number of the preliminary display panels P-DP is not limited thereto. That is, for one mother substrate MP, one, two, or three preliminary display panels P-DP may be prepared, or five or more thereof may be prepared. Compared to the aforementioned display panel DP (see FIG. 3 and FIG. 4), the contents described above may be equally applied, except that the preliminary display panel P-DP is in a state before the encapsulation layer TFE (see FIG. 3 and FIG. 4) is provided.

FIG. 8B schematically shows the operation S200 (see FIG. 7) of forming the first inorganic layer INL1 on the preliminary display panel P-DP. The first inorganic layer INL1 may be formed through a chemical vapor deposition (CVD) method using a first mask MSK1. The first inorganic layer INL1 may be formed in a region corresponding to an opening OP-MSK1 of the first mask MSK1. On a plane, the opening OP-MSK1 of the first mask MSK1 may overlap the active region AA (see FIG. 5) and the peripheral region NAA (see FIG. 5). For example, the opening OP-MSK1 of the first mask MSK1 may overlap the entire region of the active region AA (see FIG. 5). In addition, the opening OP-MSK1 of the first mask MSK1 may overlap at least a partial region of the peripheral region NAA (see FIG. 5).

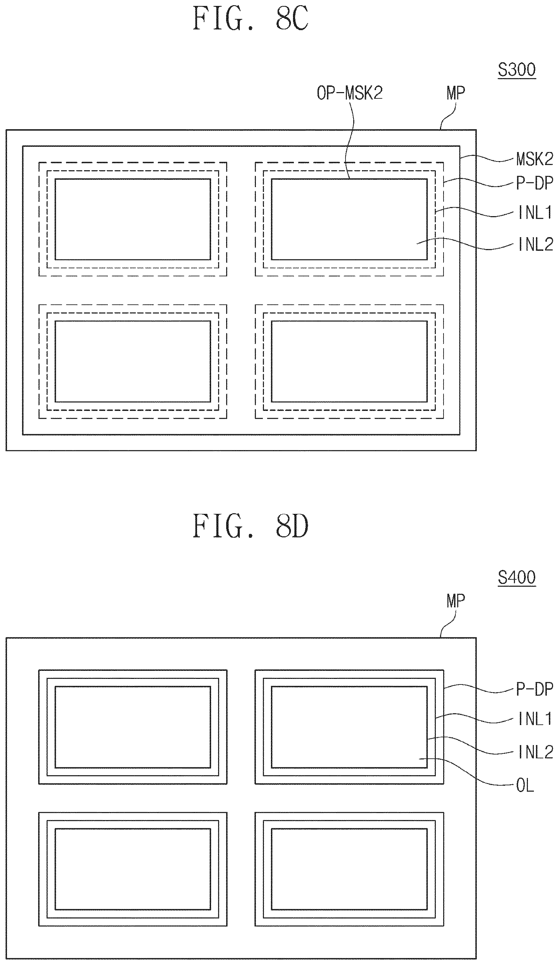

FIG. 8C schematically shows the operation S300 (see FIG. 7) of forming the second inorganic layer INL2 on the first inorganic layer INL1. The second inorganic layer INL2 may be formed through a chemical vapor deposition (CVD) method using a second mask MSK2. The second inorganic layer INL2 may be provided in a region corresponding to an opening OP-MSK2 of the second mask MSK2. On a plane, the opening OP-MSK2 of the second mask MSK2 may overlap the active region AA (see FIG. 5). In addition, the opening OP-MSK2 of the second mask MSK2 may not overlap (e.g., may be separated in plan view from) the peripheral region NAA (see FIG. 5). The second inorganic layer INL2 may have a higher oxygen content than the first inorganic layer INL1, and thus, a region in which the second inorganic layer INL2 is provided may be hydrophilic.

FIG. 8D schematically shows the operation S400 (see FIG. 7) of forming the organic layer OL on the second inorganic layer INL2. The organic layer OL may be formed by coating an organic material through an inkjet process. The organic layer OL may be formed by coating a monomer. Because the second inorganic layer INL2 is hydrophilic, suitable spreadability may be exhibited if a monomer is coated. In addition, because the second inorganic layer INL2 is formed only in the active region AA, the monomer may be coated without overflowing into the peripheral region NAA. Therefore, an ashing process for removing the monomer overflown into the peripheral region NAA may be omitted, or minimally performed.

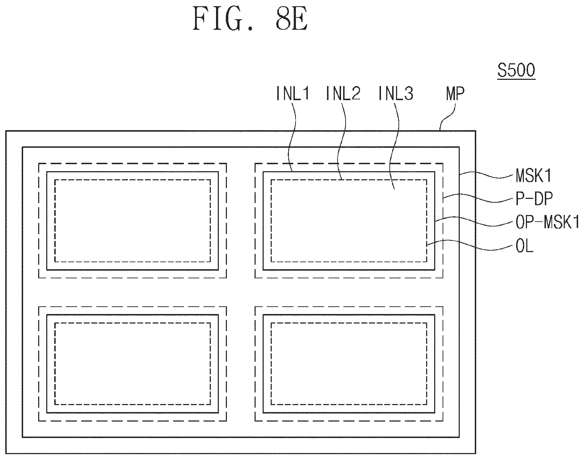

FIG. 8E schematically shows the operation S500 (see FIG. 7) of forming the third inorganic layer INL3 on the organic layer OL. The third inorganic layer INL3 may be formed through a chemical vapor deposition (CVD) method using the first mask MSK1. The third inorganic layer INL3 may be provided in a region corresponding to the opening OP-MSK1 of the first mask MSK1. On a plane, the opening OP-MSK1 of the first mask MSK1 may overlap the active region AA (see FIG. 5) and the peripheral region NAA (see FIG. 5). For example, the opening OP-MSK1 of the first mask MSK1 may overlap the entire region of the active region AA (see FIG. 5). In addition, the opening OP-MSK1 of the first mask MSK1 may overlap at least a partial region of the peripheral region NAA (see FIG. 5).

Meanwhile, the method for manufacturing the display panel DP (see FIG. 3) may further include subjecting at least a portion of a surface of the first inorganic layer INL1 to hydrophobization treatment. The surface of the first inorganic layer INL1 to be hydrophobized may refer to a surface on which the first inorganic layer INL1 is adjacent to the third inorganic layer INL3 or the second inorganic layer INL2. The at least a portion of the surface of the first inorganic layer INL1 may include a region overlapping the peripheral region NAA (see FIG. 5) on a plane. The same description described above with reference to FIG. 6A and FIG. 6B may be equally applied to a region to be subjected to hydrophobization treatment.

The hydrophobization treatment operation may be an operation of performing plasma treatment on a surface using a gas having a fluorine group. For example, the plasma treatment may be performed using NF₃, SF₆, CF₄, or HF gas. The depth of the first inorganic layer INL1 to be hydrophobized may be from 1000 Å to 1500 Å from a surface thereof.

At least a portion of the surface of the hydrophobized first inorganic layer INL1 is hydrophobic. Therefore, in the operation S400 (see FIG. 7) of proving the organic layer OL, the monomer coated on the second inorganic layer INL2 may not be covered by the second inorganic layer INL2, and may not overflow into a region in which the first inorganic layer INL1 is exposed.

As discussed, embodiments may provide a display panel comprising: a base layer comprising an active region, and a peripheral region adjacent to the active region; a light-emitting element layer above the base layer; and an encapsulation layer above the light-emitting element layer, and comprising a first inorganic layer, a second inorganic layer above the first inorganic layer, an organic layer above the second inorganic layer, and a third inorganic layer above the organic layer, wherein the second inorganic layer comprises a non-metal oxide and wherein the second inorganic layer and the organic layer overlap the active region.

The peripheral region may surround the active region.

Pixels may be located in the active region, and in some embodiments the pixels are not located in the peripheral region. The peripheral region may be defined along the edge of a display surface. The peripheral region may surround the active region.

In some embodiments, the light-emitting element layer is above the base layer, but not above the peripheral region.

The encapsulation layer may extend from over the base layer to over the peripheral region.

A portion of the first inorganic layer overlapping the peripheral region may contact the third inorganic layer.

The encapsulation layer may be located on/above the light-emitting element layer. The encapsulation layer may cover the light-emitting element layer. The encapsulation layer may be located in the active region in which the light-emitting element layer EDL is located, and may be arranged to extend in the peripheral region in which the light-emitting element layer is not located.

Embodiments may provide a display panel comprising: a base layer comprising an active region, and a peripheral region adjacent to the active region; a light-emitting element in the active region; a dam pattern in the peripheral region; a first inorganic layer covering the light-emitting element; a second inorganic layer above the first inorganic layer and comprising a non-metal oxide; an organic layer above the second inorganic layer; and a third inorganic layer above the organic layer, wherein the second inorganic layer and the organic layer are inside of the dam pattern in plan view, and wherein an edge of the first inorganic layer and an edge of the third inorganic layer are outside of the dam pattern in plan view.

The peripheral region may surround the active region in plan view, and the dam pattern may be located surrounding the active region. The dam pattern may include a first dam pattern and a second dam pattern.

The first dam pattern may be located on the inside of, or inwardly from, the second dam pattern. That is, the first dam pattern may be located between the second dam pattern and the active region in plan view.

According to the above description, a display panel of the present disclosure includes an encapsulation layer having suitable coating quality, and thus may exhibit suitable reliability.

In addition, a method for manufacturing a display panel of the present disclosure applies a process for forming an encapsulation layer with improved coating quality, and thus may improve the reliability of the display panel.

Although the present disclosure has been described with reference to preferred embodiments of the present disclosure, it will be understood by those skilled in the art that various modifications and changes in form and details may be made therein without departing from the scope of the present disclosure as set forth in the following claims.

Accordingly, the technical scope of the present disclosure is not intended to be limited to the contents set forth in the detailed description of the specification, but is intended to be defined by the appended claims, with functional equivalents thereof to be included therein.

## Claims

1. A display panel comprising:
a base layer comprising an active region, and a peripheral region adjacent to the active region;
a light-emitting element layer above the base layer; and
an encapsulation layer above the light-emitting element layer, and comprising a first inorganic layer, a second inorganic layer above the first inorganic layer, an organic layer above the second inorganic layer, and a third inorganic layer above the organic layer,
wherein the second inorganic layer comprises a non-metal oxide and
wherein the second inorganic layer and the organic layer overlap the active region.

2. The display panel of claim 1, wherein a portion of the first inorganic layer overlapping the peripheral region contacts the third inorganic layer.

3. The display panel of claim 1 or 2, wherein an area of the second inorganic layer and an area of the organic layer are smaller than an area of the first inorganic layer in plan view.

4. The display panel of any one of claims 1 to 3, wherein the first inorganic layer comprises silicon oxynitride, wherein the second inorganic layer comprises silicon oxide or silicon oxynitride, and wherein a content of oxygen atoms in the second inorganic layer is greater than a content of oxygen atoms in the first inorganic layer; optionally wherein a composition ratio of the oxygen atoms in the second inorganic layer is about 0.15 to about 1.0 based on silicon atoms; and/or
wherein the second inorganic layer is hydrophilic.

5. The display panel of any one of claims 1 to 4, wherein at least a portion of a surface of the first inorganic layer adjacent to the third inorganic layer is hydrophobic, and
wherein the at least a portion of the first inorganic layer comprises a region overlapping the peripheral region in plan view.

6. The display panel of any one of claims 1 to 5, wherein the peripheral region surrounds the active region in plan view.

7. A display panel comprising:
a base layer comprising an active region, and a peripheral region adjacent to the active region;
a light-emitting element in the active region;
a dam pattern in the peripheral region;
a first inorganic layer covering the light-emitting element;
a second inorganic layer above the first inorganic layer and comprising a non-metal oxide;
an organic layer above the second inorganic layer; and
a third inorganic layer above the organic layer,
wherein the second inorganic layer and the organic layer are inside of the dam pattern in plan view, and
wherein an edge of the first inorganic layer and an edge of the third inorganic layer are outside of the dam pattern in plan view.

8. The display panel of claim 7, wherein the peripheral region surrounds the active region in plan view, and wherein the dam pattern surrounds the active region in plan view; and/or
wherein an edge of the second inorganic layer and an edge of the organic layer are substantially aligned; and wherein the edge of the first inorganic layer and the edge of the third inorganic layer are substantially aligned.

9. The display panel of claim 7 or 8, wherein the first inorganic layer comprises silicon oxynitride, wherein the second inorganic layer comprises silicon oxide or silicon oxynitride, and wherein a content of oxygen atoms in the second inorganic layer is greater than a content of oxygen atoms in the first inorganic layer; and/or
wherein the second inorganic layer is hydrophilic.

10. The display panel of any one of claims 7 to 9, wherein at least a portion of a surface of the first inorganic layer adjacent to the third inorganic layer is hydrophobic, and
wherein the at least a portion of the first inorganic layer comprises a region overlapping the peripheral region in plan view.

11. The display panel of any one of claims 1 to 10, wherein a roughness of a surface of the organic layer adjacent to the third inorganic layer is about 10 nm or less.

12. The display panel of any one of claims 1 to 11, wherein the base layer comprises a glass substrate.

13. A method for manufacturing a display panel, the method comprising:
preparing a preliminary display panel comprising a base layer having an active region, and a peripheral region adjacent to the active region, and a light-emitting element layer above the base layer;
forming a first inorganic layer on the preliminary display panel using a first mask;
forming a second inorganic layer comprising a non-metal oxide on the first inorganic layer using a second mask;
forming an organic layer on the second inorganic layer; and
forming a third inorganic layer on the organic layer using the first mask,
wherein an area of an opening of the first mask is larger than an area of an opening of the second mask,
wherein the opening of the first mask overlaps the active region and the peripheral region, and
wherein the opening of the second mask overlaps the active region, and does not overlap the peripheral region.

14. The method of claim 13, wherein the first inorganic layer comprises silicon oxynitride, wherein the second inorganic layer comprises silicon oxide or silicon oxynitride, and wherein a content of oxygen atoms in the second inorganic layer is greater than a content of oxygen atoms in the first inorganic layer; and/or
wherein the second inorganic layer is hydrophilic.

15. The method of claim 14 or 15, further comprising subjecting at least a portion of a surface of the first inorganic layer, which comprises a region overlapping the peripheral region, to hydrophobization treatment;
optionally wherein the hydrophobization treatment comprises plasma treatment using NF₃, SF₆, CF₄, or HF gas.
